# EUROPÄISCHE PATENTSCHRIFT

(11) **EP 1 295 334 B1**
(45) Veröffentlichungstag und Bekanntmachung des Hinweises auf die Patenterteilung: **30.07.2008**
(21) Anmeldenummer: 01955204.1
(22) Anmeldetag: 06.06.2001
(51) Int. Cl.: H01L 23/00

(54) **HERMETISCHES HOCHFREQUENZMODUL UND VERFAHREN ZUR HERSTELLUNG**
HERMETIC HIGH FREQUENCY MODULE AND METHOD FOR PRODUCING THE SAME
MODULE HAUTE FREQUENCE HERMETIQUE ET SON PROCEDE DE PRODUCTION

(30) Priorität: 28.06.2000 DE 10031407
(43) Veröffentlichungstag der Anmeldung: 26.03.2003
(73) Patentinhaber: EADS Deutschland GmbH, 85521 Ottobrunn (DE)
(72) Erfinder: GRUPP, Markus, 89610 Oberdischingen (DE); SCHMIDT, Dieter, 89264 Weissenhorn (DE)
(74) Vertreter: Meel, Thomas
(86) Internationale Anmeldenummer: PCT/DE2001/002117
(87) Internationale Veröffentlichungsnummer: WO 2002/001630

(56) Entgegenhaltungen:
- FR-A- 2 717 981
- US-A- 5 574 314
- PATENT ABSTRACTS OF JAPAN vol. 011, no. 217 (E-523), 14. Juli 1987 (1987-07-14) & JP 62 037950 A (MATSUSHITA ELECTRONICS CORP), 18. Februar 1987 (1987-02-18)

## Beschreibung

Die Erfindung bezieht sich auf eine Anordnung nach dem Oberbegriff des Patentanspruchs 1 sowie auf ein Verfahren nach dem Oberbegriff des Patentanspruchs 9.

Die erfindungsgemäßen Millimeterwellen Kommunikationsmodule arbeiten beispielsweise im GHz-Bereich und werden zur Datenübertragung in der Verkehrstechnik eingesetzt.

Zur Herstellung von Metall-Keramikverbundstrukturen für Hohlleiterauskopplungen in Millimeterwellen Kommunikationsmodulen werden die Antennensubstrate auf Hohlleiterdurchgänge in Mikrowellengehäusen unter hermetischem Abschluß gelötet. Bei derzeit zur Verfügung stehenden Fertigungsprozessen werden für einen hermetischen Abschluss sog. Preforms verwendet, die als Zwischenlagen zwischen Keramikdeckel und Gehäuse eingebracht werden. Wichtige Kriterien für die Qualität derartiger Verbindungen sind deren Wechseltemperaturbeständigkeit und Zuverlässigkeit im Dauerbetrieb.

Zudem spielt der Ausschluss von Feuchte aus dem Gehäuseinneren für die elektrische Funktion eine wesentliche Rolle.

Aus der Schrift WO 91/09699 bekannt ist ein hermetischer Verschluss keramisch/ metallischer Gehäuse für integrierte Schaltkreise. Dabei werden keramische Gehäusedeckel mit Gold/Zinn Preforms montiert und gelötet. Der Lötprozess erfolgt bei einer Temperatur unter400 °C über eine mit dem Gehäuse in kontaktstehende Heizelektrode, wobei Deckel und Gehäuse während des Lötvorgangs aufeinandergepresst werden.

Ein Hochfrequenzmodul mit den Merkmalen gemäß des Oberbegriffs des Patentanspruchs 1 ist aus US 5,574,314 bekannt.

Ein wesentlicher Nachteil bisheriger Herstellungsverfahren besteht in der geringen Positioniertoleranz beim Fügen der Einzelbaugruppen, die eine automatische Fertigung erschweren oder sogar unmöglich machen. Der Aufbau von Hohlleiterauskopplungen mit Preforms und den üblicherweise für eine genaue Positionierung des Gehäusedeckels verwendeten Passerstiften, ist mit einem erhöhten Zeitaufwand verbunden und nur bei kleinen Stückzahlen vertretbar.

Der Erfindung liegt die Aufgabe zugrunde, ein Herstellungsverfahren und eine Anordnung mit erhöhten Postitioniertoleranzen bei der automatisierten Herstellung hermetischer HF-Module anzugeben.

Die Erfindung wird in Bezug auf die Anordnung durch die Merkmale des Patentanspruchs 1 und in Bezug auf das Verfahren durch die Merkmale des Patentanspruchs 9 wiedergegeben. Die weiteren Ansprüche enthalten vorteilhafte Aus- und Weiterbildungen der Erfindung.

Die Erfindung beinhaltet ein Hochfrequenzmodul mit Hohlleiterstruktur, bestehend aus einem Gehäuseboden und Gehäusedeckel, bevorzugt aus Keramik. Gehäuseboden und Deckel sind in ihrem Ausdehnungsverhalten aufeinander abgestimmt. Beispielsweise besteht der Gehäusedeckel aus Aluminiumoxid und der Gehäuseboden aus Mo30Cu. Auf dem Gehäusedeckel ist die Justageeinrichtung zur Positionierung auf dem Gehäuseboden angebracht. Zur Vorbeugung gegen Korrosion ist das metallische Gehäuse mit einer Nickel und Goldschicht veredelt.
Die Justageeinrichtung besteht aus einer Photolackerhöhung, die sich, ausgehend von der Gehäusedeckeloberfläche, konisch verjüngt. Die Justageeinrichtung greift bei der Montage in den Hohlleiter ein. Die Schichtdicke der Justageeinrichtung beträgt ungefähr 100 bis 200 µm. Gehäusedeckel und Gehäuseboden sind mittels Loten fest miteinander verbunden. Bevorzugt werden Lote verwendet, die galvanisch in Lotdepots eingebracht sind. Hierzu ist das Lot entweder lokal auf die mit dem Gehäuseboden in Kontakt stehende Gehäusedeckelfläche aufgebracht oder auch in im Deckel strukturierte Vias eingebracht.

Das Verfahren zur Herstellung eines Hochfrequenzmoduls beinhaltet folgende Schritte:
- die Kontaktfläche des Gehäusedeckel wird mit dem Gehäuseboden mit einer ersten Photolackmaske für eine galvanische Metallabscheidung strukturiert,
- eine Gold/Zinn Schichtenfolge des Lotdepots wird abgeschieden,
- die erste Photolackmaske wird entfernt
- eine zweite Photolackmaske als Justageeinrichtung wird strukturiert,
- die Zinnoberfläche wird von Oxid gereinigt,
- der Gehäusedeckel wird auf dem Gehäuseboden zentriert und fixiert,
- der Gehäusedeckel wird mit dem Gehäuseboden verlötet,
- der Lack der Justageeinrichtung wird naßchemisch entfernt.

Bevorzugt wird der Lack der Justageeinrichtung naßchemisch mit einer erwärmten Kaliumhydroxidlösung entfernt.

Ein besonderer Vorteil der Erfindung besteht in der Vereinfachnung beim manuellen Aufbau von Hohlleiterübergängen und ermöglicht eine automatische Bestückung der Module für eine Fertigung größerer Stückzahlen.
Ein weiterer Vorteil besteht in der kostengünstigen Einbindung der Fertigungsschritte in die Herstellung von Dünnschichtsubstraten. Dies stellt eine wesentliche Vereinfachung des Montageprozesses dar.

Im folgenden wird die Erfindung anhand von vorteilhaften Ausführungsbeispielen unter Bezugnahme auf schematische Zeichnungen in den Figuren näher erläutert. Es zeigen:
- Fig. 1: Hochfrequenzmodul mit Hohlleiterstruktur,
- Fig. 2: Aufsicht der Justageeinrichtung,
- Fig. 3: Gehäusedeckel mit Justageeinrichtung und Lotdepot.

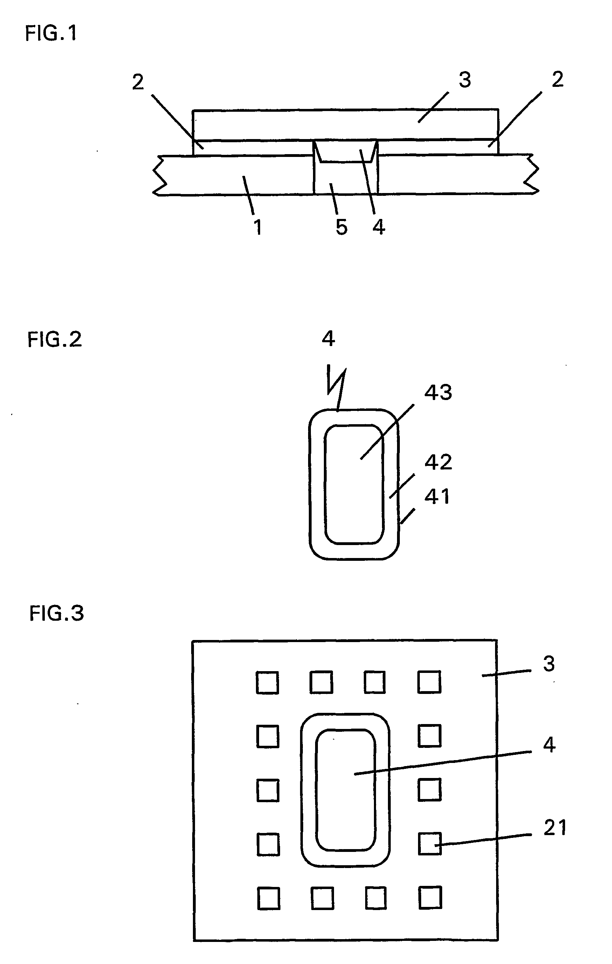

In einem Ausführungsbeispiel gemäß Fig. 1 wird ein Hochfrequenzmodul mit Hohlleiterstruktur, bestehend aus einem Gehäuseboden 1 und Gehäusedeckel 3 aus Keramik dargestellt, bei dem auf den Gehäusedeckel 3 eine Justageeinrichtung 4 zur Positionierung im Hohlleiter auf dem Gehäuseboden 1 aufgebracht ist.
Zur Zentrierung und Fixierung auf dem Hohlleiterdurchgang besteht die Justageeinrichtung 4 aus einer Photolackerhöhung, die sich ausgehend vom Gehäusedeckel 3 konisch verjüngt (Fig. 2). Die Justageeinrichtung 4 greift bei der Montage mit der oberen Konusfläche 43 in den Hohlleiter 5 ein, wird an der Seitenfläche 42 entlang bis zur Basisfläche 41 geführt und wird mit geringer Auflagekraft im Hohlleiter zentriert. Die Dimensionierung der Basisfläche 41 ist dergestalt, daß diese paßgenau auf die Dimension des Hohlleiters abgestimmt ist. Die Schichtdicke der Justageeinrichtung 4 beträgt ungefähr 100 bis 200 µm. Zur Erzielung derartiger Schichtdicken werden üblicherweise zwei bis drei Lackfolien einer Dicke von ca. 70 µm übereinander aufgebracht. Mittels der Belichtungsparameter beim photolithographischen Prozeß wird die Flankensteilheit der Seitenflächen 42 eingestellt. Gehäusedeckel 3 und Gehäuseboden 1 sind mittels Lote 2 fest miteinander verbunden, die galvanisch lokal in Lotdepots 21 eingebracht sind.

Das Verfahren zur Herstellung eines Hochfrequenzmoduls beinhaltet Schritte, bei denen auf eine Verwendung eines Preforms verzichtet wird.
Die Kontaktfläche des Gehäusedeckels 3 wird mit dem Gehäuseboden 1 mit einer ersten Photolackmaske für eine galvanische Metallabscheidung strukturiert. Die hierfür verwendete Gold/Zinn Schichtenfolge des Lotdepots wird so abgeschieden, daß deren jeweilige Dicken an die Mengenverhältnisse der eutektischen Legierung annähernd angepaßt sind. Bevorzugt wird eine Schichtdickenverhältnis der Au:Sn Schichten von ungefähr 1,5:1 angestrebt und damit die Lotdepots 21 gefüllt (Fig. 3). Die jeweiligen Schichtdicken liegen im Bereich zwischen 12 µm Au/8 µm Sn bis 9 µm Au/6 µm Sn.
Nach dem Befüllen der Lotdepots 21 wird die erste Photolackmaske wieder entfernt. Eine zweite Photolackmaske als Justageeinrichtung 4 wird daraufhin strukturiert. Die Maske besteht üblicherweise aus einer photolithographisch strukturierten Lackfolie. Die Oxidoberfläche des Zinns wird in einem Wasserstoff-Vakuum-Reflowofen bei einer Temperatur von ca. 300°C und einer Prozeßzeit von einigen Minuten abgetragen. In einem weiteren Verfahrensschritt wird der Gehäusedeckel 3 auf dem Gehäuseboden 1 zentriert und fixiert.
Der Gehäusedeckel 3 wird mit dem Gehäuseboden 1 durch flußmittelfreies Löten, beispielsweise mit AuSn Loten in Wasserstoffatmosphäre, fest miteinander verbunden. Der Lötprozeß wird ebenfalls in einem Wasserstoff-Vakuum-Reflowofen bevorzugt unter Verwendung des eutektischen Lotwerkstoffes mit einer ungefähren Zusammensetzung von 80 Vol.% Au und 20 Vol.% Sn durchgeführt. Der Schmelzpunkt der eutektischen Verbindung beträgt 280°C. Der Lötprozeß des unter reduzierender Wasserstoffatmosphäre in Verbindung mit Stickstoff als Schutzgas betriebenen Ofens wird bei einer Temperatur um 320°C über eine Dauer von einigen Minuten durchgeführt. Die verwendete Gold- und Zinnschicht, die auf der Lötseite des Substrates in Depots abgeschieden wird und im Verlauf des Temperprozesses zu einer vollständigen Durchmischung der Au/Sn-Schichten unter Ausbildung eines homogenen Gefüges führt, ersetzt die sonst verwendeten Preforms.
Der Lack der Justageeinrichtung 4 wird naßchemisch bevorzugt mit einer erwärmten Kaliumhydroxidlösung entfernt. Hierzu wird das Modul für ungefähr 10 min in 50 %-ige Kaliumhydroxidlösung einer Temperatur von 70°C getaucht.

## Patentansprüche

1. Hochfrequenzmodul mit Hohlleiterstruktur, bestehend aus Gehäuseboden (1) und Gehäusedeckel (3), wobei auf den Gehäusedeckel (3) eine Justageeinrichtung (4) zur Positionierung auf dem Gehäuseboden (1) angebracht ist,
**dadurch gekennzeichnet, dass**
die Justageeinrichtung (4) aus einer Photolackerhöhung besteht.

2. Hochfrequenzmodul nach Anspruch 1, **dadurch gekennzeichnet, dass** die Justageeinrichtung (4) sich ausgehend vom Gehäusedeckel (3) konisch verjüngt.

3. Hochfrequenzmodul nach einem der Ansprüche 1 bis 2, **dadurch gekennzeichnet, dass** der Gehäusedeckel (3) und der Gehäuseboden (1) mittels Loten (2) fest miteinander verbunden sind.

4. Hochfrequenzmodul nach Anspruch 3, **dadurch gekennzeichnet, dass** galvanische Lote (2) galvanisch in Lotdepots eingebracht sind.

5. Hochfrequenzmodul nach einem der vorhergehenden Ansprüche 1 bis 4, **dadurch gekennzeichnet, dass** der Gehäusedeckel (3) aus Keramik besteht.

6. Hochfrequenzmodul nach einem der vorhergehenden Ansprüche 1 bis 5, **dadurch gekennzeichnet, dass** die Justageeinrichtung (4) in den Hohlleiter (5) eingreift.

7. Hochfrequenzmodul nach einem der vorhergehenden Ansprüche 1 bis 6, **dadurch gekennzeichnet, dass** die Schichtdicke der Justageeinrichtung (4) ungefähr 100 bis 200 µm beträgt.

8. Verfahren zur Herstellung eines Hochfrequenzmoduls, bestehend aus einem Gehäusedeckel (3) mit Lotdepots (21) und einem Gehäuseboden (1), wobei
- die Kontaktfläche des Gehäusedeckels (3) mit dem Gehäuseboden (1) mit einer ersten Photolackmaske für eine galvanische Metallabscheidung strukturiert wird,
- eine Gold/Zinn Schichtenfolge des Lotdepots (21) abgeschieden wird,
- die erste Photolackmaske entfernt wird,
- auf dem Gehäusedeckel (3) eine zweite Photolackmaske als Justageeinrichtung (4) strukturiert wird,
- die Zinnoberfläche von Oxid gereinigt wird,
- der Gehäusedeckel (3) auf dem Gehäuseboden (1) zentriert und fixiert wird,
- der Gehäusedeckel (3) mit dem Gehäuseboden (1) verlötet wird,
- der Lack der Justageeinrichtung (4) nasschemisch entfernt wird.

9. Verfahren nach Anspruch 8, **dadurch gekennzeichnet, dass** der Lack der Justageeinrichtung (4) nasschemisch mit einer erwärmten Kaliumhydroxidlösung entfernt wird.

## Claims

1. High-frequency module with a hollow conductor structure, comprising a housing base (1) and a housing cover (3), an adjusting device (4) for positioning on the housing base (1) being mounted on the housing cover (3), **characterized in that** the adjusting device (4) comprises a raised photosensitive resist part.

2. High-frequency module according to Claim 1,
**characterized in that** the adjusting device (4) tapers conically, starting from the housing cover (3) .

3. High-frequency module according to either of Claims 1 and 2, **characterized in that** the housing cover (3) and the housing base (1) are firmly connected to each other by means of solders (2).

4. High-frequency module according to Claim 3,
**characterized in that** galvanic solders (2) are introduced galvanically into solder depots.

5. High-frequency module according to one of the preceding Claims 1 to 4, **characterized in that** the housing cover (3) consists of ceramic.

6. High-frequency module according to one of the preceding Claims 1 to 5, **characterized in that** the adjusting device (4) engages in the hollow conductor (5).

7. High-frequency module according to one of the preceding Claims 1 to 6, **characterized in that** the layer thickness of the adjusting device (4) is approximately 100 to 200 µm.

8. Method for producing a high-frequency module, comprising a housing cover (3) with solder depots (21) and a housing base (1), wherein
- the contact area of the housing cover (3) with the housing base (1) is structured with a first photoresist mask for galvanic metal deposition,
- a gold/tin layer sequence of the solder depot (21) is deposited,
- the first photoresist mask is removed,
- a second photoresist mask is structured on the housing cover (3) as an adjusting device (4),
- the tin surface is cleaned of oxide,
- the housing cover (3) is centred and fixed on the housing base (1),
- the housing cover (3) is soldered to the housing base (1),
- the resist of the adjusting device (4) is wet-chemically removed.

9. Method according to Claim 8, **characterized in that** the resist of the adjusting device (4) is wet-chemically removed by using a heated potassium hydroxide solution.

## Revendications

1. Module à haute fréquence à structure de conducteur creux, constitué d'un fond de boîtier (1) et d'un couvercle de boîtier (3), un dispositif d'ajustement (4) étant installé sur le couvercle de boîtier (3) en vue de placer ce dernier sur le fond de boîtier (1),
**caractérisé en ce que**
le dispositif d'ajustement (4) est constitué d'un épaississement en photovernis.

2. Module à haute fréquence selon la revendication 1, **caractérisé en ce que** le dispositif d'ajustement (4) se rétrécit coniquement à partir du couvercle de boîtier (3).

3. Module à haute fréquence selon l'une des revendications 1 à 2, **caractérisé en ce que** le couvercle de boîtier (3) et le fond de boîtier (1) sont reliés solidairement l'un à l'autre par brasage (2).

4. Module à haute fréquence selon la revendication 3, **caractérisé en ce que** de la brasure galvanique (2) est placée par galvanisation en dépôts de brasure.

5. Module à haute fréquence selon l'une des revendications 1 à 4 qui précèdent, **caractérisé en ce que** le couvercle de boîtier (3) est constitué de céramique.

6. Module à haute fréquence selon l'une des revendications 1 à 5 qui précèdent, **caractérisé en ce que** le dispositif d'ajustement (4) s'engage dans le conducteur creux (5).

7. Module à haute fréquence selon l'une des revendications 1 à 6 qui précèdent, **caractérisé en ce que** l'épaisseur de la couche du dispositif d'ajustement (4) est comprise entre environ 100 et 200 µm.

8. Procédé de fabrication d'un module à haute fréquence, constitué d'un couvercle de boîtier (3) doté de dépôts (21) de brasure et d'un fond de boîtier (1), dans lequel
- la surface de contact entre le couvercle de boîtier (3) et le fond de boîtier (1) est structurée à l'aide d'un premier masque de photovernis en vue d'un dépôt électrolytique de métal,
- une succession de couches d'or et d'étain du dépôt (21) de brasure est déposée,
- le premier masque de photovernis est retiré,
- un deuxième masque de photovernis qui sert de dispositif d'ajustement (4) est structuré sur le couvercle de boîtier (3),
- la surface d'étain est débarrassée de ses oxydes,
- le boîtier de couvercle (3) est centré et fixé sur le fond de couvercle (1),
- le couvercle de boîtier (3) est brasé sur le fond de boîtier (1) et
- le vernis du dispositif d'ajustement (4) est enlevé chimiquement en conditions humides.

9. Procédé selon la revendication 8, **caractérisé en ce que** le vernis du dispositif d'ajustement (4) est enlevé chimiquement en conditions humides à l'aide d'une solution chauffée d'hydroxyde de potassium.
